Europäisches Patentamt

European Patent Office

Office européen des brevets

(11) Veröffentlichungsnummer: **0 329 240**
**A2**

# (12) EUROPÄISCHE PATENTANMELDUNG

(21) Anmeldenummer: **89200333.6**

(22) Anmeldetag: **13.02.89**

(51) Int. Cl.4: **G01N 24/08**

(30) Priorität: **17.02.88 DE 3804924**

(43) Veröffentlichungstag der Anmeldung:
**23.08.89 Patentblatt 89/34**

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB NL**

(72) Erfinder: **Kunz, Dietmar Wilhelm, Dr.**
**Berliner Strasse 10**
**D-2085 Quickborn(DE)**
Erfinder: **Bomsdorf, Hartwin, Dr.**
**Mansteinstrasse 30**
**D-2000 Hamburg 20(DE)**
Erfinder: **Wieland, Jürgen, Dr.**
**Am Hang 17**
**D-2080 Pinneberg(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Verfahren zur Ermittlung der spektralen Verteilung der Kernmagnetisierung in einem begrenzten Volumenbereich und Anordnung zur Durchführung des Verfahrens.**

(57) Die Erfindung betrifft ein Verfahren zur Ermittlung der spektralen Verteilung der Kermagnetisierung in einem begrenten Volumenbereich sowie eine Anordnung zur Durchführung des Verfahrens. Jede Sequenz umfaßt dabei eine Teilsequenz, die die Kernmagnetisierung überall außerhalb einer definierten Schicht dephasiert. Dieser Teilsequenz folgen drei Hochfrequenzimpulse, von denen die ersten beiden schichtselektiv sind. Diese drei Hochfrequenzimpulse regen die Kernmagnetisierung in einem durch den Schnittbereich der erwähnten Schicht und zweier zu einander und dazu senkrechter Schichten an. Zur Unterdrückung unerwünschter FID-Signale und zur Vervollständigung des Spektrums erfolgt ein Phasencycling.

EP 0 329 240 A2

Fig. 3

## Verfahren zur Ermittlung der spektralen Verteilung der Kernmagnetisierung in einem begrenzten Volumenbereich und Anordnung zur Durchführung des Verfahrens

Die Erfindung betrifft ein Verfahren zur Ermittlung der Kernmagnetisierungsverteilung in einem begrenzten Volumenbereich mit mehreren Sequenzen, wobei in jeder Sequenz in Anwesenheit eines stationären homogenen Magnetfeldes drei Hochfrequenzimpulse auf einen Untersuchungsbereich einwirken, von denen der erste und der zweite mit je einem von zwei Magnetfeldern zusammenwirken, deren Gradienten zueinander senkrecht verlaufen, und wobei die in jeder Sequenz erzeugten stimulierten Echosignale einer Addition und einer Fourier-Transformation unterzogen werden, sowie eine Anordnung zur Durchführung des Verfahrens.

Ein solches Verfahren ist aus der EP-OS 87 200 261 bekannt. Ein gewisser Nachteil dieses Verfahrens besteht darin, daß auch der dritte der drei Hochfrequenzimpulse ein sogenannter schichtselektiver Impuls ist, der in Verbindung mit einem magnetischen Gradientenfeld erzeugt wird und daß auch nach diesem Impuls und kurz vor dem Empfang des stimulierten Echosignals erneut ein magnetisches Gradientenfeld ein- und ausgeschaltet wird. Die magnetischen Gradientenfelder während und nach dem Hochfrequenzimpuls erzeugen Wirbelströme, die länger wirksam sind als die sie erzeugenden magnetischen Gradientenfelder. Diese Wirbelströme haben ihrerseits Magnetfelder zur Folge, die die Phase des stimulierten Echosignals störend beeinflussen.

Es ist Aufgabe der vorliegenden Erfindung, ein Verfahren der eingangs genannten Art so auszugestalten, daß die Wirbelströme der für die Selektion des Volumenbereiches erforderlichen magnetischen Gradientenfelder das stimulierte Echosignal allenfalls noch in stark reduziertem Maße beeinflussen.

Diese Aufgabe wird erfindungsgemäß dadurch gelöst, daß jede Sequenz eine den drei Hochfrequenzimpulsen vorangehenden Teilsequenz umfaßt, durch die die Kernmagnetisierung überall außerhalb einer Schicht dephasiert wird, die parallel zu der durch die Richtungen der beiden Gradientenrichtungen definierten Ebene verläuft und daß die Sequenz in Sequenzenfolgen verabfolgt werden, wobei in jeder Sequenzenfolge die Sequenzen n mal wiederholt werden, wobei n größer oder gleich 3 ist, daß sich alle Sequenzen einer Sequenzenfolge untereinander in der Phasendifferenz zwischen dem ersten und dem zweiten Hochfrequenzimpuls um $360°/n$ oder ein ganzzahliges, von Null verschiedenes Vielfaches davon unterscheiden und daß die durch die Sequenzen erzeugten Kernresonanzsignale so zueinander addiert werden, daß sich die vom dritten Hochfrequenzimpuls erzeugten FID-Signale kompensieren.

Bei der Erfindung wird durch die Teilsequenz die Kernmagnetisierung im Untersuchungsbereich überall außerhalb einer bestimmten Schicht dephasiert. Durch die beiden ersten Hochfrequenzimpulse nach der Teilsequenz wird die Kernmagnetisierung im Schnittbereich der erwähnten Schicht und zweier dazu senkrechter Schichten in die Richtung des homogenen stationären Magnetfeldes oder antiparallel dazu gekippt. Der dritte Hochfrequenzimpuls erzeugt daher in diesem Schnittbereich eine stimuliertes Echosignal. Da während und nach diesem dritten Hochfrequenzimpuls kein magnetisches Gradientenfeld ein- und ausgeschaltet wird, bleibt dieses stimulierte Echosignal von Wirbelströmen weitgehend unbeeinflußt.

Durch eine einzige, gegebenfalls identisch wiederholte Sequenz dieser Art kann indes nicht die Kernmagnetisierung aller Stoffe im Untersuchungsbereich angeregt werden. Außerdem erzeugt der dritte Hochfrequenzimpuls in der Schicht außerhalb des Schnittbereiches störende FID-Signale. Durch das im Anspruch näher definierte sogenannte Phasencycling lassen sich aber alle Frequenz-Komponenten in dem jeweils durch die magnetischen Gradientenfelder bestimmten Volumenbereich erfassen und die unerwünschten FID-Signale unterdrücken, die von Teilen der Schicht außerhalb dieses Volumenbereiches stammen.

Eine Weiterbildung der Erfindung sieht vor, daß die Phase des dritten Hochfrequenzimpulses jeder Sequenz innerhalb einer Sequenzenfolge sich um $360°/n$ oder ein ganzzahliges Vielfaches dieses Wertes von der Phase dieses Hochfrequenzimpulses in den anderen Sequenzen unterscheidet. Diese Weiterbildung gestattet es, die in den einzelnen Sequenzen erzeugten Kernresonanzsignale unmittelbar zueinander zu addieren und danach einer Fourier-Transformation zu unterwerfen bzw. zunächst damit eine Fourier-Transformation durchzuführen und die resultierenden Spektren einander zu überlagern.

Die Erfindung wird nachstehend anhand der Zeichnung näher erläutert. Es zeigen:

Fig. 1 ein Kernspin-Untersuchungsgerät zur Durchführung erfindungsgemäßen Verfahrens,
Fig. 2 ein Blockschaltbild eines solchen Gerätes,
Fig. 3 den zeitlichen Verlauf verschiedener Signale bei dem erfindungsgemäßen Verfahren und
Fig. 4 die Lage der durch die verschiedenen Hochfrequenzimpulse beeinflußten Volumenbereiche.

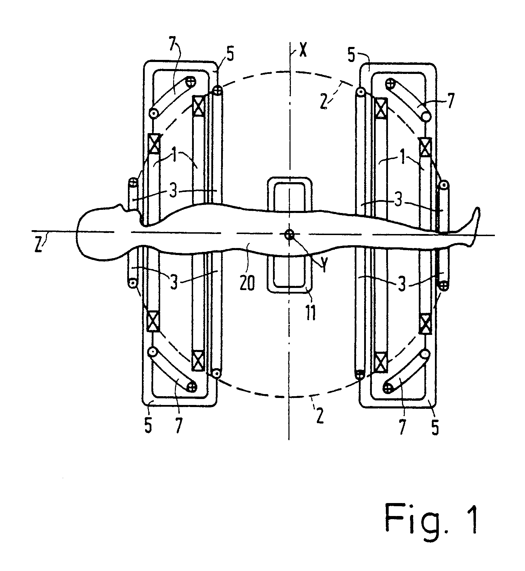

Das in Fig. 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystem bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. - Im Anschluß an drei Hochfrequenzimpulse dient die Hochfrequenzspule 11 zum Empfangen des im Untersuchungsbereich erzeugten stimulierten Echosignals. Statt dessen kann aber auch eine gesonderte Hochfrequenz-Empfangsspule verwendet werden.

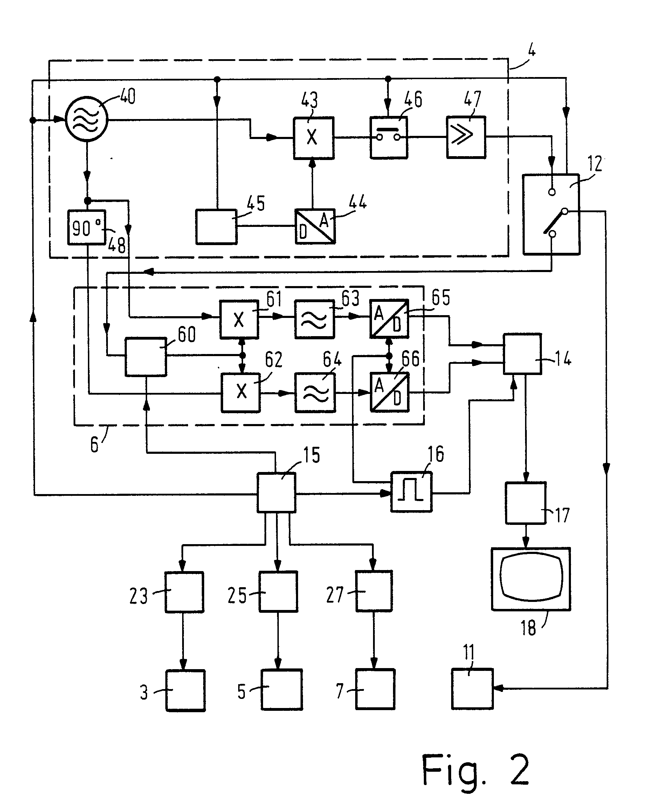

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz der anzuregenden Atomkerne bei der von den Spulen 1 erzeugten Feldstärke aufweist. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird -gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte stimulierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequenten Anteile durchlassen, je einem Analog-Digital-Wandler 65 bzw. 66 zugeführt. Dieser setzt die analogen Signale der einen Quadratur-Demodulator bildenden Schaltungen 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 durch das Signal S16 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden vom Stromgenerator 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner 17 zugeführt, der daraus durch eine diskrete Fourier-Transformation die Spektralverteilung der Kernmagnetisierung ermittelt und die ermittelte Verteilung an einer geeigneten Wiedergabeeinheit, z.B. einem Monitor 18, ausgibt.

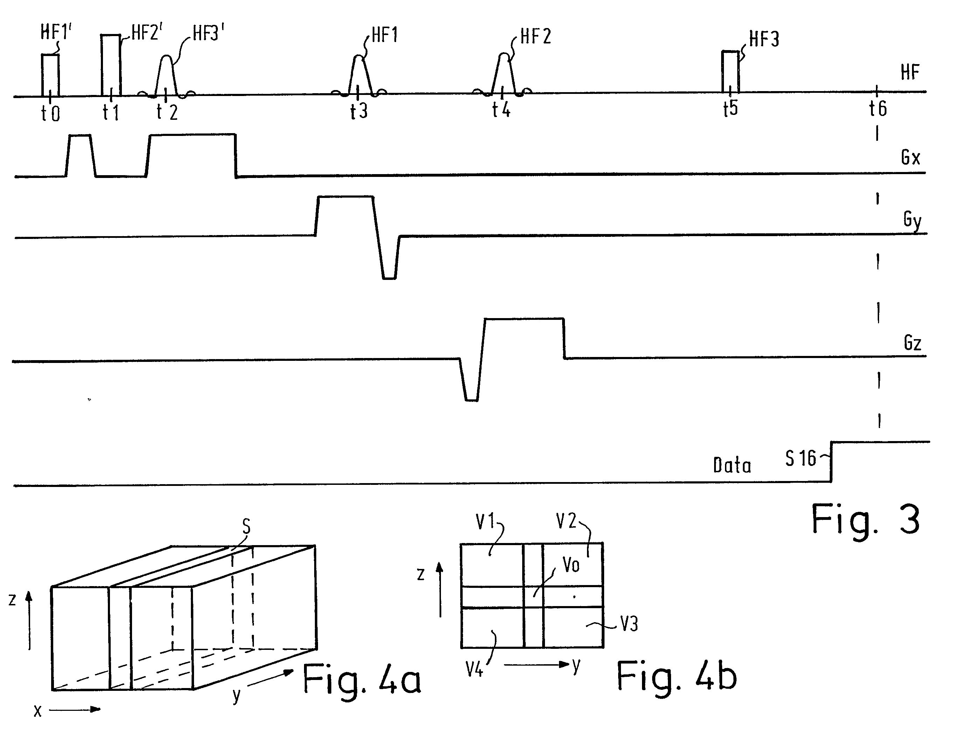

In Fig. 3 ist der zeitliche Verlauf von verschiedenen mit der Schaltung nach Fig. 2 empfangenen oder erzeugten Signalen für das erfindungsgemäße Verfahren dargestellt. Die erste Zeile zeigt den zeitlichen Verlauf des Ausgangssignals des Hochfrequenzerzeugers 4. Die zweite, dritte bzw. vierte Zeile zeigen den zeitlichen Verlauf des magnetischen Gradientenfeldes Gx, Gy bzw. Gz, das mittels der Spulenanordnung 7, 5 bzw. 3 und der Generator 27, 25 bzw. 23 erzeugt wird. In der fünften Zeile ist der zeitliche Verlauf des von der Steuereinrichtung 15 dem Taktimpulsgenerator 16 zugeführten Steuersignals dargestellt.

Die Impulse HF1$'$, HF2$'$ und HF3$'$ bewirken zusammen mit dem magnetischen Gradientenfeld Gx, daß in einer zur x-Richtung senkrechten Schicht S (vergl. Fig.4a) die Kernmagnetisierung in z-Richtung bzw. in -z-Richtung verläuft, d.h. parallel oder antiparallel zum stationären homogenen Magnetfeld und daß die Kernmagnetisierung überall außerhalb der Schicht dephasiert ist.

Der erste Hochfrequenzimpuls HF1$'$ ist ein breitbandiger 90$^\circ$-Hochfrequenzimpuls, dessen Mitte zur Zeit t0 auftritt. Das mit diesem Hochfrequenzimpuls verbundene FID-Signal wird durch das magnetische Gradientenfeld Gx, das zwische diesem Hochfrequenzimpuls und dem nächsten Hochfrequenzimpuls HF2$'$ eingeschaltet, ist dephasiert. Der zweite Hochfrequnzimpuls HF2$'$ ist ein breitbandiger 180$^\circ$-Hochfrequenzimpuls, der zur Zeit t1 auftritt. Ein schmalbandiger 90$^\circ$-Hochfrequenzimpuls HF3$'$ tritt zur Zeit t2 auf, wobei t2 vorzugsweise so gewählt ist, daß der 180$^\circ$ Hochfrequenzimpuls HF2$'$ in der Mitte zwischen den beiden Hochfrequenzimpulsen HF1$'$ und HF3$'$ liegt. Während dieses Hochfrequenzimpulses HF3$'$ ist das magnetische Gradientenfeld Gx wieder eingeschaltet, so daß die Kernmagnetisierung in einer zur x-Achse senkrechten Schicht - der Schicht S - in anderer Weise beeinflußt wird als die Kernmagnetisierung außerhalb der Schicht; das Integral über das magnetische Gradientenfeld Gx zwischen den beiden Hochfrequenzimpulsen HF1$'$ und HF2$'$ ist dabei gleich dem Integral über das Feld Gx nach dem zweiten Hochfrequenzimpuls HF2 bis zur Zeit t2.

Der Hochfrequenzimpuls HF1$'$ regt den gesamten Untersuchungsbereich an, weil er nicht schichtselektiv ist. Das damit verknüpfte FID-Signal (d.h. das durch den freien Induktionszerfall hervorgerufene Signal) wird jedoch durch das nach diesem Hochfrequenzimpuls und vor dem 180$^\circ$-Hoch frequenzimpuls HF2$'$ ein- und ausgeschaltete magnetische Gradientenfeld Gx dephasiert. Dadurch, daß nach dem zweiten Hochfrequenzimpuls das magnetische Gradientenfeld noch einmal eingeschaltet wird und bis zum Zeitpunkt t2 der erwähnten Integralgleichung genügt, ergibt sich zur Zeit t2 in dem Untersuchungsbereich ein Spin-Echo-Signal. Durch den 90$^\circ$-Hochfrequenzimpuls HF3$'$ wird aber in der erwähnten Schicht S innerhalb des Untersuchungsbereiches die Kernmagnetisierung erneut um 90$^\circ$ gedreht, so daß danach in dieser Schicht die Kernmagnetisierung entweder wieder in z-Richtung oder antiparallel dazu verläuft. Da der Hochfrequenzimpuls HF3$'$ aber nur für die Schicht S wirksam ist, ist zur Zeit t2 die Kernmagnetisierung außerhalb der Schicht S im gesamten Untersuchungsbereich angeregt. Diese Kernmagnetisierung wird jedoch dadurch dephasiert, daß das magnetische Gradientenfeld Gx über den Zeitpunkt t2 hinaus eingeschaltet bleibt. Nach dem Abschalten dieses Gradientenfeldes liefert also der gesamte Untersuchungsbereich kein Kernspinresonanz-Signal mehr; während aber die Kernmagnetisierung innerhalb der Schicht durch einen weiteren Impuls noch angeregt werden kann, ist dies für die dephasierte Kernmagnetisierung außerhalb der Schicht nicht möglich - jedenfalls solange die Kernmagnetisierung dephasiert ist. Eine solche Teilsequenz ist an sich bekannt - vgl. J.Magn.Reson. 67, 148-155 (1986).

Nach dieser Teilsequenz folgt ein schmalbandiger 90$^\circ$-Hochfrequenzimpuls HF1 (zur Zeit t3), mit dem die Einschaltung eines magnetischen Gradientenfeldes Gy einhergeht. Der zeitliche Verlauf des magnetischen Gradientenfeldes Gy ist dabei so gewählt, daß das Integral über dieses magnetische Gradientenfeld vom Zeitpunkt t3 an bis zum Abschalten dieses Feldes gerade den Wert Null hat. Das magnetische Gradientenfeld Gy ist bereits vor Beginn des Hochfrequenz impulses HF1 eingeschaltet. Dadurch wird die Kernmagnetisierung außerhalb der Schicht S zusätzlichdephasiert. Der Hochfrequenzimpuls HF1 bewirkt in Verbindung mit dem magnetischen Gradientenfeld Gy, daß die Kernmagnetisierung in einer zur y-Richtung senkrechten Schicht angeregt wird.

Nach dem 90$^\circ$-Impuls HF1 folgt zur Zeit t4 ein weiterer schmalbandiger 90$^\circ$-Hochfrequenzimpuls HF2. Bei diesem Hochfrequenzimpuls ist das magnetische Gradientenfeld Gz eingeschaltet und zwar so, daß das zeitliche Integral vom Beginn der Einschaltung bis zur Zeit t4 gerade den Wert Null hat. Das Gradientenfeld

4

bleibt nach der Zeit t4 noch eine gewisse Zeit eingeschaltet, endet aber vor dem nächsten Hochfrequenzimpuls HF3. Da während dieses Hochfrequenzimpulses kein magnetisches Gradientenfeld eingeschaltet ist, erfaßt er den gesamten Untersuchungsbereich. Es kann sich dabei um einen breitbandigen ("harten") 90°-Hochfreqenzimpuls handeln, aber auch um einen frequenzselektiven 90°-Hochfrequenzimpuls. Wenn dieser Hochfrequenzimpuls so gestaltet ist, daß die Kernmagnetisierung von an Fett gebundenen Protonen dadurch nicht angeregt wird, wird das Auftreten von Fettsignalen verhindert, die bei der Kernresonanzspektroskopie, beispielsweise des Gehirns, stören können. Wenn die spektroskopische Untersuchung durch starke Signale von in Wasser gebundenen Protonen gestört wird, muß der frequenzselektive Hochfrequenzimpuls HF3 so gestaltet sein, daß sein Spektrum die für die Anregung von Wasser erforderliche Frequenz nicht enthält.

Der zweite Hochfrequenzimpuls HF2 beeinflußt die Kernmagnetisierung in einer zur z-Achse senkrechten Schicht. Der dritte Hochfrequenzimpuls HF3, der zur Zeit t5 auftritt, ruft im Schnittbereich Vo (vergl. Fig. 4b) der Schicht S mit den durch die Hochfrequenzimpulse HF1 und HF2 angeregten Schichten als Kernresonanz-Signal ein stimuliertes Echosignal hervor. Dieses tritt zur Zeit t6 in einem Abstand zum Hochfrequenzimpuls HF3 auf, der dem zeitlichen Abstand (t4-t3) des Hochfrequenzimpulses HF2 vom Hochfrequenzimpuls HF1 entspricht. Deshalb ist zur Zeit t6 oder auch schon kurz davor das von der Steuereinrichtung 15 für den Taktgenerator 16 gelieferte Freigabesignal S16 vorhanden (vergl. Fig. 3, Zeile 5), so daß die von der Freigabe an auftretenden Signalkomponenten in den Kanälen 61..65 und 62..66 erfaßt und im Speicher 14 gespeichert werden. Dieses Signal wird zur Bestimmung seines Frequenzspektrums bzw. der Spektralverteilung im Rechner 17 einer diskreten Fourier-Transformation unterzogen - vorzugsweise nach einer Mittelung über die stimulierten Echosignale von Sequenzen, die mit der in Fig. 3 dargestellten Sequenz gleichartig sind.

Der Vorteil dieses Verfahrens gegenüber dem eingangs erwähnten bekannten verfahren besteht darin, daß während des dritten Hochfrequenzimpulses HF3 und danach kein magnetisches Gradientenfeld eingeschaltet ist. Zum Zeitpunkt des Auftretens des stimulierten Echosignals sind die durch das zuletzt eingeschaltete magnetische Gradientenfeld (das ist das Feld Gz während und nach dem zweitenHochfreqeunzimpuls HF2) hervorgerufenen Wirbelströme praktisch vollständig abgeklungen, so daß das stimulierte Echosignal und damit das daraus abgeleitete Frequenzspektrum von diesen Wirbelströmen weitgehend unbeeinflußt bleibt.

Jedoch ist das von der in Fig. 3 dargestellten Sequenz hervorgerufene stimulierte Echosignal für die Ermittlung des Frequenzspektrums nicht nur wegen des schlechten Signal-Rauschverhältnisses ungeeignet (dieses ließe sich durch Wiederholung und durch Mittelwertbildung über die gewonnenen Signale vergrößern), sondern vor allem deshalb, weil in diesem Kernresonanzsignal ein Teil der durch den ersten Hochfrequenzimpuls angeregten Spektralkomponenten unterdrückt ist und weil darüber hinaus andere Kernresonanzsignale auftreten, die nicht von der Kernmagnetisierung im erwünschten Bereich Vo abhängen. Dies wird im folgenden näher erläutert:

Diejenigen Stoffe innerhalb des Bereichs Vo, deren Larmorfrequenz innerhalb des Zeitraums t4 - t3 der Mittenfrequenz der Hochfrequenzimpulse um eine Viertel Periode (oder ein ungeradzahliges Vielfaches davon) vor- oder nacheilt, werden durch den zweiten Hochfrequenzimpuls HF2 nicht in z-Richtung oder antiparallel dazu gekippt, und deshalb durch das nach t4 noch wirksame Gradientenfeld Gz dephasiert, so daß ihr Spektralanteil im stimulierten Echosignal nicht erscheinen kann. Die Komponenten, deren Larmorfrequenz zwischen der Larmorfrequenz der erwähnten Stoffe und einer Larmorfrequenz liegt, die mit der Mittenfrequenz der Hochfrequenzimpulse HF1 und HF2 exakt in Phase ist, werden mehr oder weniger unterdrückt.

Es kommt hinzu, daß sich dem stimulierten Echosignal aus dem Bereich Vo FID-Signale überlagern, die aus Bereichen innerhalb der Schicht stammen, die außerhalb der durch die Hochfrequenzimpulse HF1 und HF2 beeinflußten Schichten liegen. In den außerhalb von Vo liegenden Teilen der erwähnten Schichten wird die Kernmagnetisierung durch einen der beiden 90° Hochfrequenzimpulse HF1 oder HF2 und durch den dritten 90° Hochfrequenzimpuls HF3 bestimmt. In diesen Teilen verläuft die Kernmagnetisierung entweder in z-Richtung oder senkrecht dazu und trägt daher nichts zum Kernresonanzsignal bei. Außerhalb dieser Schichten erfolgt eine Anregung jedoch nur durch den dritten Hochfrequenzimpuls HF3, und daher erzeugt dieser dritte Hochfrequenzimpuls in diesen Bereichen der Schicht S FID-Signale, die sich dem stimulierten Echosignal aus dem Bereich Vo überlagern. Fig. 4b, die eine Draufsicht auf die Schicht S darstellt zeigt die Lage dieser Bereiche V1,V2, V3 und V4.

Die vorstehend beschriebenen, ganz oder teilweise unterdrückten Spektralbereiche lassen sich aber vollständig erfassen und die erwähnten FID-Signale lassen sich unterdrücken, wenn das im folgenden beschriebene Phasencycling angewendet wird. Unter Phasencycling ist zu verstehen, daß eine Sequenz jeweils nach einer bestimmten Repetitionszeit mehrmals wiederholt wird, wobei die Phase wenigstens eines Hochfrequenzimpulses von Sequenz zu Sequenz verändert wird. Unter Phase eines Hochfrequenzimpulses wird dabei der Winkel verstanden, den in einem mit der Mittenfrequenz des Hochfrequenzimpulses mitrotierenden Koordinatensystem die mit der gleichen Drehrichtung mitrotierende Magnetfeldkomponente des betreffenden Hochfrequenzimpulses in Bezug auf die x- (oder y-) Achse einnimmt.

In der folgenden Tabelle ist eine für ein solches Phasencycling geeignete Folge von Sequenzen dargestellt:

|  | HF1 | HF2 | HF3 |
|---|---|---|---|
| 1.Sequenz | x | x | x |
| 2.Sequenz | x | x + 120° | x - 120° |
| 3.Sequenz | x | x + 240° | x - 240° |

Bei der ersten Sequenz haben die drei Hochfrequenzimpulse HF1, HF2 und HF3 die gleiche Phase. Bei der zweiten Sequenz ist die Phase des zweiten Hochfrequenzimpulses gegenüber der Phase des ersten Hochfrequenzimpulses um +120° versetzt, während die Phase des dritten Hochfrequenzimpulses gegenüber derjenigen des ersten Hochfrequenzimpulses um -120° versetzt ist. In der dritten Sequenz schließlich ist die Phase des zweiten Hochfre quenzimpulses HF2 um 240° und die des dritten Hochfrequenzimpulses HF3 um -240° gegenüber der Phase des ersten Hochfrequenzimpulses HF1 versetzt.

Die Verschiebung der Phasen der Hochfrequenzimpulse kann beispielsweise dadurch erfolgen, daß die Frequenz des Oszillators 40 nach dem ersten bzw. dem zweiten Hochfrequenzimpuls kurzfristig verändert wird, bis gegenüber der ursprünglichen Schwingung eine (zeitliche) Phasenverschiebung erreicht ist, die der gewünschten (räumlichen) Phasenverschiebung entspricht, wonach die Frequenz wieder auf ihren ursprünglichen Wert gesteuert wird. Die Schwingung des Oszillators ist dann gegenüber der ursprünglichen Schwingung um beispielsweise 120° versetzt, so daß auch die mit dem rotierenden Koordinatensystem mitrotierende Komponente des von der Spule 11 erzeugten Hochfrequenzmagnetfeldes in diesem Koordinantensystem eine um 120° versetzte Lage einnimmt. Nach dem dritten Hochfrequenzimpuls wird die Phase. des Oszillators 40 wieder in die ursprüngliche Lage gebracht, beispielsweise durch vorüber gehende Änderung der Frequenz.

Weil die Phasen des dritten Hochfrequenzimpulses in den drei Sequenzen gegeneinander um jeweils 120° versetzt sind, ergibt sich die gleiche Phasenverschiebung auch bei den aus diesem dritten Impuls in den einzelnen Sequenzen jeweils resultierenden FID-Signalen. Infolgedessen kompensieren sich diese Signale, wenn sie zueinander addiert werden. Da weiterhin von Sequenz zu Sequenz der Phasenunterschied zwischen dem ersten Hochfrequenzimpuls und dem zweiten Hochfrequenzimpuls sich um jeweils 120° ändert, werden bei der zweiten und der dritten Sequenz auch diejenigen Komponenten durch den zweiten Hochfrequenzimpuls HF2 angeregt, deren Larmorfrequenz so liegt, daß sich in dem Zeitraum zwischen dem ersten und dem zweiten Hochfrequenzimpuls gegenüber der Oszillatorfrequenz eine Phasenverschiebung von 90° (oder einem ungeraden ganzzahligen Vielfachen davon) ergibt und die aus diesem Grund bei der ersten Sequenz nicht angeregt werden. Infolgedessen ergibt sich aus der Addition der aus den drei Sequenzen resultierenden stimulierten Echosignale ein Summensignal, daß die Frequenzkomponenten von allen im Volumenelement Vo enthaltenen Stoffen enthält, die durch die Hochfrequenzimpulse HF1, HF2 und HF3 anregbar sind. Aus der Fourier-Transformation über dieses Summensignal resultiert daher das Frequenzspektrum des Bereiches Vo. Zur Verbesserung des Signal-Rauschverhältnisses wird die aus den drei Sequenzen bestehende Sequenzenfolge vorzugsweise mehrmals wiederholt, und die dabei entstehenden Komponenten werden addiert und danach einer Fourier-Transformation unterzogen.

Die in der obigen Tabelle beschriebene Sequenzenfolge setzt voraus, daß die Phase um 120° versetzt ist. Bei vielen Spektrometern ist die Phase aber nur um 90° bzw. ein Vielfaches davon änderbar. Die folgende Tabelle zeigt daher eine für derartige Spektrometer ausführbare Sequenzenfolge mit vier Sequenzen, die ebenfalls das gewünschte Phasencycling ergibt.

|  | HF1 | HF2 | HF3 |
|---|---|---|---|
| 1. Sequenz | x | x | x |
| 2. Sequenz | x | y | $\bar{y}$ |
| 3. Sequenz | x | $\bar{x}$ | $\bar{x}$ |
| 4. Sequenz | x | $\bar{y}$ | y |

Bei der ersten Sequenz wird durch alle drei Hochfrequenzimpulse HF1..HF3 die Kernmagnetisierung um die x-Achse im Uhrzeigersinn gekippt, d.h. die mitrotierende Komponente des Hochfrequenzmagnetfeldes verläuft in y-Richtung. Bei der zweiten Sequenz kippt der zweite Hochfrequenzimpuls die Kernmagnetisierung um die y-Achse und der dritte Hochfrequenzimpuls die Kernmagnetisierung um die -y-Achse, d.h. die mitrotierende Komponente des Hochfrequenzmagnetfeldes verläuft in +x- bzw. in -x-Richtung. Durch den zweiten Impuls HF2 in der zweiten Sequenz werden alle die Komponenten maximal angeregt, die durch den zweiten Hochfrequenzimpuls in der ersten Sequenz nicht angeregt werden, weil sie zum Zeitpunkt dieses Hochfrequenzimpulses gerade parallel zur mitrotierenden Komponente des Magnetfeldes oder antiparallel dazu verlaufen.

Bei der dritten Sequenz wird die Kernmagnetisierung durch den zweiten bzw. den dritten Hochfrequenzimpuls um die -x-Achse gekippt, während bei dem ersten Hochfrequenzimpuls die Kernmagnetisierung um die x-Achse gekippt wird, d.h. der zweite und der dritte Hochfrequenzimpuls HF2 und HF3 haben gegenüber dem ersten Hochfrequenzimpuls HF1 eine um 180° versetzt Phase. Entsprechend ist die Phase des zweiten Hochfrequenzimpulses bei der vierten Sequenz gegenüber derjenigen des ersten Hochfrequenzimpulses um 270° (bzw. -90°) versetzt, während die Phase des dritten Hochfrequenzimpulses dabei um 90° versetzt ist.

Aus dieser zweiten Tabelle ist ersichtlich, daß der dritte Hochfrequenzimpuls in der ersten bzw. der zweiten Sequenz die entgegengesetzte Phasenlage hat, wie in der dritten bzw. in der vierten Sequenz.

Infolgedessen kompensieren sich die FID-Signalanteile in den Kernresonanzsignalen, wenn diese zueinander addiert werden. Ebenfalls ist ersichtlich, daß der zweite Hochfrequenzimpuls in der zweiten Sequenz die Signalkomponenten beeinflußt, die der zweite Hochfrequenzimpuls HF2 in der ersten Sequenz nicht beeinflußen kann - und umgekehrt. Das gleiche gilt für den zweiten Hochfrequenzimpuls in der dritten und in der vierten Sequenz. Infolgedessen ergibt die Summation der durch die vier Sequenzen erzeugten Kernresonanzsignale ein Summensignal, das ein von allen Komponenten im Bereich Vo in gleicher Weise beeinflußtes stimuliertes Echosignal darstellt.

Die Summation erfolgt dadurch, daß die nach den einzelnen Sequenzen auftretenden Ausgangssignale S65 des A/D-Wandlers 65 zueinander addiert werden, indem die Datenworte, die das Kernresonanzsignal in der gleichen zeitlichen Lage in bezug auf die zugehörige Sequenz darstellen, jeweils zueinander addiert werden. Das gleiche geschieht mit den Ausgangssignalen S66 des A/D-Wandlers S66. Die Signale S65 und S66 lassen sich als Real- bzw. Imaginärteil eines komplexen Signals $Sk = S65 + iS66$ auffassen, aus dem durch eine diskrete, komplexe Fourier-Transformation das (komplexe) Frequenzspektrum bestimmt wird. Da die Fourier-Transformation eine lineare Operation ist, könnte gegebenenfalls auch die Reihenfolge zwischen Summation und Fourier-Transformation vertauscht werden.

Zur Verbesserung des Signal-Rausch-Verhältnisses ist es sinnvoll, die angegebenen Sequenzenfolgen mehrmals zu wiederholen und die Signale S65 und S66, die dabei auftreten, vor der Fourier-Transformation in der angegebenen Weise zu addieren. Dabei ist es nicht wichtig, daß die Sequenzen einer Sequenzenfolge unmittelbar aufeinander folgen. Es kann beispielsweise sinnvoll sein, zunächst 50 mal hintereinander die erste Sequenz der in der zweiten Tabelle angegebenen Sequenzenfolge zu erzeugen, dann 50 mal die zweite Sequenz, usw.

Die Phasenlage der Hochfrequenzimpulse HF1', HF2', HF3' die den drei Hochfrequenzimpulsen HF1, HF2 und HF3 vorangehen, kann beliebig gewählt werden; sie muß also nicht variiert werden.

Die Bezeichnung der Phasenlage der ersten Hochfrequenzimpulse in den Sequenzenfolge mit "x" ist an sich willkürlich; wichtig ist nur, daß sich die Phasenlage der darauf folgenden Impulse HF2 und HF3 davon in der vorgenannten Weise unterscheidet.

Allgemein gelten für das zum Ausgleich der mit einer einzigen Sequenz gemäß Fig. 3 verbundenen Nachteile erforderliche Phasencycling folgende Regeln:

a) eine Sequenzenfolge muß wenigstens drei Sequenzen umfassen,

b) bei einer Sequenzenfolge mit n Sequenzen muß die Phasendifferenz zwischen dem ersten Hochfrequenzimpuls HF1 und dem zweiten Hochfrequenzimpuls HF2 einer Sequenz sich von den entsprechenden Phasendifferenzen der anderen Sequenzen dieser Sequenzenfolge um 360°/n oder um ein ganzzahliges Vielfaches davon unterscheiden,

c) die Phase des dritten Hochfrequenzimpulses in Bezug auf eine Referenzphase (beispielsweise x), die in 61 zur Demodulation verwendet wird, sollte für jede Sequenz der Sequenzenfolge gerade das Negative der nach b) gewählten Phasendifferenz sein.

Ist dies nicht der Fall, dann sollten die Ausgangssignale S65 und S66 - vor der Addition zu den entsprechenden Signalen vorangegangener Sequenzen -ersetzt werden durch die Zwischensignale S65' bzw. S66' gemäß den folgenden Gleichungen:

$$S65' = S65 \cos\beta + S66 \sin\beta \qquad (1)$$

7

$$S66' = S66 \cos\beta - S65 \sin\beta \quad (2)$$

Dabei ist $\beta$ der Unterschied zwischen der Phase, den der dritte Hochfrequenzimpuls HF3 nach der Bedingung c) haben sollte, und der tatsächlichen Phase.

Nach den in den beiden Tabellen definierten Sequenzenfolgen hat der dritte Hochfrequenzimpuls jeder Sequenz jeweils die Sollphase, infolgedessen ist $\beta = 0$, und gemäß Gleichung (1) und Gleichung (2) geht S65 über in S65 und S66' über in S66. Wenn hingegen beispielsweise die Phase HF3 des dritten Hochfrequenzimpulses der vierten Sequenz (zweiten Tabelle) ersetzt würde durch einen Hochfrequenzimpuls mit der Phase x, würde $\beta$ 90° betragen und aus den Gleichungen (1) und (2) ergäbe sich dann

$$S65' = S66 \text{ und } S66' = -S65$$

d.h., das durch den Analog-Digital-Wandler 65 digitalisierte Kernresonanzsignal S65 müßte von den in den vorangegangenen Sequenzen vom Analog-Digital-Wandler 66 digitalisierten und gespeicherten Signalen S66 subtrahiert werden, und das Ausgangssignal S66 des Analog-Digital-Wandlers 66 müßte zu den Ausgangssignalen S65 des Analog-Digital-Wandlers 65 bei den vorangegangenen drei Sequenzen addiert werden. Der dritte Hochfrequenzimpuls der dritten Sequenz kann auch die gleiche Phase haben wie der dritte Hochfrequenzimpuls HF3 der ersten Sequenz in der zweiten Tabelle. In diesem Fall ist $\beta = 180°$, und es gilt gemäß den Gleichungen (1) und (2)

$$S65 = -S65 \text{ und } S66 = -S66.$$

Entsprechend könnte x auch als Phase des dritten Hochfrequenzimpulses HF3 in der zweiten Sequenz gewählt werden ($\beta = 270$), so daß der dritte Hochfrequenzimpuls HF3 in allen vier Sequenzen jeweils die gleiche Phase hätte. Wenn dies gemäß den Gleichungen (1) und (2) ausgegelichen wird, ergibt sich überdies der Vorteil, daß sich gegebenenfalls vorhandene Fehleinstellungen des Nullpunktes der Empfangseinheit herausheben.

In der medizinischen Diagnostik ist oft auch der Nachweis von Metaboliten erwünscht. Diese besitzen in der Regel eine J-Kopplung mit einer skalaren Kopplungskonstante J von beispielsweise 7 Hz. Das Spektrum derartiger Metaboliten hängt cosinusförmig von dem zeitlichen Abstand t4-t3 zwischen den beiden Hochfrequenzimpulsen HF2 und HF1 ab, wobei die Nullstelle sich ergibt, wenn dieser zeitliche Abstand dem Kehrwert des doppelten der skalaren Kopplungskonstante entspricht, d.h. etwa bei ca. 70 ms liegt. Um eine Auslöschung der Spektralkomponenten dieser Metaboliten zu vermeiden, muß daher der zeitliche Abstand zwischen den beiden Hochfrequenzimpulsen HF1 und HF2 so klein wie möglich sein, beispielsweise 10 ms, oder er muß doppelt so groß sein wie die zur Auslöschung erforderliche Zeit, beispielsweise rund 140 ms.

Es ist möglich, die Sequenz so auszugestalten, daß die von dem Wasseranteil im Volumen Vo hervorgerufenen Signalanteile unterdrückt werden. Zu diesem Zweck kann an Stelle des dritten Hochfrequenzimpulses HF3 ein frequenzselektiver Hochfrequenzimpuls verwendet werden, beispielsweise ein sogenannter binomialer Hochfrequenzimpuls, der so gestaltet ist, daß er die Kernspins von an Wasser gebundenen Wasserstoffprotonen nicht anregen kann.

## Ansprüche

1. Verfahren zur Ermittlung der Kernmagnetisierungsverteilung in einem begrenzten Volumenbereich mit mehreren Sequenzen, wobei in jeder Sequenz in Anwesenheit eines stationären homogenen Magnetfeldes drei Hochfrequenzimpulse auf einen Untersuchungsbereich einwirken, von denen der erste und der zweite mit je einem von zwei Magnetfeldern zusammenwirken deren Gradienten zueinander senkrecht verlaufen, und wobei die in jeder Sequenz erzeugten stimulierten Echosignale einer Addition und einer Fourier-Transformation unterzogen werden, dadurch gekennzeichnet, daß jede Sequenz eine den drei Hochfrequenzimpulsen (HF1...HF3) vorangehende Teilsequenz (HF1'...HF3') umfaßt, durch die die Kernmagnetisierung überall außerhalb einer Schicht (S) dephasiert wird, die parallel zu der durch die beiden Gradientenrichtungen (Gy, Gz) definierten Ebene verläuft und daß die Sequenzen in Sequenzenfolgen verabfolgt werden, wobei in jeder Sequenzenfolge die Sequenzen n mal wiederholt werden, wobei n größer oder gleich 3 ist, daß sich alle Sequenzen einer Sequenzenfolge untereinander in der Phasendifferenz zwischen dem ersten und dem zweiten Hochfrequenzimpuls um 360° /n oder ein ganzzahliges, von Null verschiedenes Vielfaches davon unterscheiden und daß die durch die Sequenzen erzeugten Kernresonanzsignale so zueinander addiert werden, daß sich die vom dritten Hochfrequenzimpuls (HF3) erzeugten FID-Signale kompensieren.

2. Verfahren nach Anspruch 1, dadurch gekennzeichnet, daß die drei Hochfrequenzimpulse (HF1...HF3) 90°-Impulse sind.

3. Verfahren nach Anspruch 1 oder 2,
dadurch gekennzeichnet, daß die Teilsequenz einen ersten $90^\circ$-Hochfrequenzimpuls (HF1') umfaßt, einen $180^\circ$-Impuls (HF2') und einen zweiten $90^\circ$-Hochfrequenzimpuls (HF3'), daß die beiden $90^\circ$-Hochfrequenzimpulse (HF1' und HF3') den gleichen Abstand von dem $180^\circ$-Hochfrequenzimpuls (HF2') haben, daß zwischen dem ersten $90^\circ$ Hochfrequenzimpuls und dem $180^\circ$ Hochfrequenzimpuls sowie nach dem $180^\circ$-Hochfrequnzimpuls ein Magnetfeld mit einem Gradienten (Gx) eingeschaltet ist, der zur Richtung der zu beeinflußenden Schicht senkrecht steht, und daß das Integral über diesen Gradienten zwischen dem ersten $90^\circ$-Hochfrequenzimpuls (HF1') und dem $180^\circ$-Hochfrequenzimpuls (HF2') gleich dem Integral über dieses Magnetfeld vom Ende des $180^\circ$-Impulses bis zur Mitte (t2) des zweiten $90^\circ$-Hochfrequenzimpulses (HF3') ist.

4. Verfahren nach Anspruch 3,
dadurch gekennzeichnet, daß das magnetische Feld über das Ende des zweiten $90^\circ$ Hochfrequenzimpulses (HF3') hinaus eingeschaltet bleibt.

5. Verfahren nach einem der vorhergehenden Ansprüche,
dadurch gekennzeichnet, daß der Abstand zwischen dem ersten (HF1) und dem zweiten Hochfrequenzimpuls (HF2) entweder dem Kehrwert der skalaren Kopplungskonstante J oder einem Vielfachen davon entspricht oder klein im Vergleich zu dem Kehrwert ist.

6. Verfahren nach einem der vorhergehenden Ansprüche,
dadurch gekennzeichnet, daß die Phase des dritten Hochfrequenzimpulses (HF3) der Sequenzen in Bezug auf eine Referenzphase (x) gleich dem Negativen der Phasendifferenz zwischen dem ersten und dem zweiten Hochfrequenzimpuls (HF1 und HF2) ist.

7. Verfahren nach einem der vorhergehenden Ansprüche,
dadurch gekennzeichnet, daß der dritte (HF3) der drei Hochfrequenzimpulse (HF1..HF3) als frequenzselektiver Hochfrequenzimpuls ausgeführt wird.

8. Einrichtung zur Durchführung des Verfahrens nach Anspruch 1, mit einem Magneten zur Erzeugung eines homogenen stationären Magnetfeldes, einer Hochfrequenzspulenanordnung zur Erzeugung eines hochfrequenten, zum stationären Magnetfeld senkrechten Magnetfeldes, einem Hochfrequenzgenerator zur Speisung der Hochfrequenzspulenanordnung mit Hochfrequenzimpulsen, einer Gradientenspulenanordnung zur Erzeugung von in Richtung des stationären Magnetfeldes verlaufenden Magnetfeldern mit in verschiedenen Richtungen verlaufenden Gradienten, mit Generatoren zur Speisung der Gradientenspulen, einer Steuereinheit zur Steuerung des Hochfrequenzgenerators und der Generatoren und mit einer Recheneinheit zur Verarbeitung des stimulierten Echosignals,
dadurch gekennzeichnet, daß die Steuereinheit so programmiert ist, daß sie mehrere Sequenzen erzeugt von denen jede eine Teilsequenz (HF1'...HF3') umfaßt, durch die die Kernmagnetisierung überal außerhalb einer Schicht (S) dephasiert wird, wonach drei Hochfrequenzimpulse (HF1..HF3) erzeugt werden, von denen der erste und der zweite in Anwesenheit eines Magnetfeldes mit senkrecht zueinander und zur Schicht verlaufendem Gradienten (Gy, Gz) auf den Untersuchungsbereich einwirken, daß Sequenzenfolgen mit n Sequenzen erzeugt werden, wobei n größer oder gleich 3 ist, bei denen sich die Phasendifferenz zwischen dem ersten und dem zweiten Hochfrequenzimpuls nach der Teilsequenz um $360^\circ$/n unterscheidet und daß die Recheneinrichtung so programmiert ist, daß die von den einzelnenSequenzen erzeugten Kernspin-Resonanzsignale addiert werden, derart daß sich die durch den dritten Hochfrequenzimpuls erzeugten FID-Signale kompensieren.

Fig. 1

Fig. 2

Fig. 3

Fig. 4a

Fig. 4b

EP 0 329 240 A2

3-Ⅲ-PHD 88-030